## Europäisches Patentamt
### European Patent Office
### Office européen des brevets

(11) Veröffentlichungsnummer: **0 012 841**
**B1**

(12) **EUROPÄISCHE PATENTSCHRIFT**

(45) Veröffentlichungstag der Patentschrift:
12.03.86

(51) Int. Cl.⁴: **G 11 C 19/28**

(21) Anmeldenummer: **79104587.5**

(22) Anmeldetag: **19.11.79**

(54) Spalten- und zeilenadressierbarer Speicher in Serien-Parallel-Serien-Konfiguration.

(30) Priorität: **29.12.78 US 974587**

(43) Veröffentlichungstag der Anmeldung:
**09.07.80 Patentblatt 80/14**

(45) Bekanntmachung des Hinweises auf die Patenterteilung:
**12.03.86 Patentblatt 86/11**

(84) Benannte Vertragsstaaten:
**DE FR GB NL SE**

(56) Entgegenhaltungen:
**US - A - 3 766 534**
**US - A - 3 890 633**
**US - A - 4 011 548**
**US - A - 4 094 009**
**US - A - 4 128 879**
**US - A - 4 152 780**

**IEEE JOURNAL OF SOLID-STATE CIRCUITS, Band SC10, Nr. 5, Oktober 1975, Seiten 268-273, New York, U.S.A., K.C. GUNSAGAR et al.: "A CCD line addressable random-access memory (LARAM)**
**IBM TECHNICAL DISCLOSURE BULLETIN, Band 21, Nr. 5, Oktober 1978, Seiten 1904-1907, Armonk, U.S.A., M. CASES et al.: "Charge-coupled device memory organization"**
**INTEL MEMORY DESIGN HANDBOOK, Intel, 1975,**

(73) Patentinhaber: **International Business Machines Corporation, Old Orchard Road, Armonk, N.Y. 10504 (US)**

(72) Erfinder: **Councill, Edwin Dayne, Country Club Road, Hopewell Junction, N.Y. 12533 (US)**
Erfinder: **Kelly, Helen Janet, 52 Tor Road, Wappingers Falls, N.Y. 12590 (US)**
Erfinder: **Lee, Hua-Tung, 2 Skyview Drive, Poughkeepsie, N.Y. 12603 (US)**

(74) Vertreter: **Rudolph, Wolfgang, Dipl.-Ing., Schönaicher Strasse 220, D-7030 Böblingen (DE)**

(56) Entgegenhaltungen: (Fortsetzung)
**Seiten 9-1 - 9-30, Santa Clara, U.S.A., B. PAPENBERG: "Design and applications of Intel's 2416 16K charge coupled device"**
**IEEE JOURNAL OF SOLID-STATE CIRCUITS, Band SC-11, Nr. 1, Februar 1976, Seiten 40-48, New York, U.S.A., MOHSEN et al.: "A 16-kbit block addressed charge-coupled memory device"**

**Beschreibung**

Die vorliegende Erfindung betrifft einen zeilenadressierbaren Speicher nach dem Oberbegriff des Anspruchs 1.

In der Technik ist die Verwendung von Ladungskopplungselementen in Datenspeichern, primär in der Form von Schieberegistern, in die Daten als serieller Bitstrom an einem Ende des Schieberegisters ein- und am anderen Ende wieder ausgelesen werden, allgemein bekannt.

In der US PS 4 011 548 ist ein Speicher in Serien-Parallel-Serien-Konfiguration mit Ladungskopplungselementen beschrieben und dargestellt. Dieser Speicher besteht aus drei Hauptteilen, wovon der erste ein serielles Eingabeschieberegister zum Empfang der Datenbits ist, der zweite ein serielles Ausgabeschieberegister ist und der dritte Teil mehrere parallele Schieberegister umfasst. Von diesen parallelen Schieberegistern ist jedes zwischen einer Speicherposition des Eingabeschieberegisters und einer Speicherposition des Ausgabeschieberegisters angeordnet, um Datenbits zu empfangen und aus der letzten Zeile eines Schieberegisters des dritten Teils in das serielle Ausgaberegister zu übertragen. Dies geschieht dadurch, dass auf einem Substrat angeordnete, zu jedem der parallelen Schieberegister gehörende, erste, zweite und dritte Phasensteuerleitungen und Steuerleitungen für Steuergates vom Eingabeschieberegister angeordnet sind und dass Phasensteuerleitungen orthogonal zu den parallelen Schieberegistern und parallel zueinander verlaufen, wogegen die Steuerleitungen parallel zu den Schieberegistern und orthogonal zu den Phasensteuerleitungen angeordnet sind. Die Elektroden, die dabei mit den Phasensteuerleitungen und den anderen Steuerleitungen verbunden sind, sind nebeneinander auf dem Substrat angeordnet. Dieser Speicher wird spaltenadressierbar betrieben. Dieser Speicher zeigt zwar gegenüber den bis dahin bekannten Speichern eine Verbesserung des Datenflusses auf, indem eine Sperrleitung eine Sperrelektrode zwischen jeder Taktphasenleitung aufweist. Diese Anordnung ist jedoch nicht geeignet, den Speicher in zwei Betriebsverfahren arbeiten zu lassen.

Um die Daten besser wahlfrei adressieren zu können, wurden herkömmliche Speicher mit Zeilenadressierung entwickelt. Ein solcher Speicher ist z.B. in der US PS 4 024 512 dargestellt. Dieser zeilenadressierbare Speicher kann so betrieben werden, dass er viele Schleifen enthält, die parallel arbeiten. Eine Schleife wird dabei aus zwei in entgegengesetzter Richtung betriebenen senkrecht zur Zeile der Eingabeschieberegister verlaufenden Schieberegister gebildet. Diese senkrecht verlaufenden Register zu den Ein- und Ausgaberegistern in der Zeile sind praktisch die Spalten eines herkömmlichen Matrixspeichers. Dadurch, dass jetzt die Möglichkeit zum Auslesen aus irgendeiner Spalte oder Schleife besteht, wird die Flexibilität eines solchen an sich zeilenadressierbaren Speichers wesentlich erhöht. Das bedeutet, dass das mit dem Speicher verbundene Benutzergerät direkten Zugriff zu den gewünschten Daten, d.h. mit der Latenzzeit Null, hat. Diese stark verbesserte Arbeitsgeschwindigkeit gegenüber einer SPS-Struktur geht jedoch auf Kosten einer geringeren Bitdichte und eines grösseren Stromverbrauchs, die beide zu höheren Speicherkosten pro Bit führen.

Weder die serielle-parallele-serielle Konstruktion noch die zeilenadressierbare Konstruktion eines Speichers liefern also das angestrebte Optimum an Betriebsbedingungen.

Die Aufgabe der Erfindung besteht darin, einen verbesserten zeilenadressierbaren Speicher in SPS-Konfiguration zu schaffen, der die erwünschten Eigenschaften eines seriellen-parallelen-seriellen Datenspeichers und diejenigen eines zeilenadressierbaren Datenspeichers hat, aus Ladungskopplungselemente zusammengesetzt ist und der ohne Einschränkung in zwei Betriebsarten betrieben werden kann.

Die erfindungsgemässe Lösung ist im Kennzeichen des Anspruchs angegeben.

Der Vorteil der vorliegenden Erfindung besteht darin, dass hier Leiter auf nur zwei Ebenen gebraucht werden und trotzdem eine hohe Betriebssicherheit und -geschwindigkeit erreicht werden. Der optimale Betrieb in zwei verschiedenen Betriebsarten wird in einem dreiphasigen seriellen Speicher durch Steuerleitungen erreicht, die Elektroden aufweisen, die jeweils zwischen den dritten und ersten Phasensteuerleitungen vorhanden sind, und alle Steuerleitungen so schaltbar sind, dass ein angelegtes Steuersignal die Weiterleitung von Datenbits von einer zu einer der folgenden Zeilen nur eines der parallelen Schieberegister oder aller parallelen Schieberegister sperrt oder zulässt.

Ein Ausführungsbeispiel der Erfindung ist in den beigefügten Zeichnungen dargestellt und wird anschliessend näher beschrieben.

Es zeigen:

Fig. 1 ein System, das im Ruhezustand durch leere Bits im seriellen Eingaberegister definiert ist,

Fign. 2A bis 2F den Datenfluss, wenn der serielle-parallele-serielle Speicher in Zeilenadressierung betrieben wird,

Fig. 3 drei Zellen, die in Ladungskopplungstechnik (CCD) ausgeführt im Weiterleitungsbetrieb betrieben werden,

Fign. 3A bis 3F Energieniveaus zur Darstellung des Ladungsflusses in der in Fig. 3 gezeigten Struktur,

Fig. 3G mehrere Kurven zur Darstellung der Steuerspannung an jeder Elektrode in Fig. 3,

Fig. 4 schematisch drei in Ladungskopplungstechnik ausgeführte Zellen, die im Haltebetrieb betrieben werden,

Fign. 4A bis 4F Energieniveaus zur Darstellung des Ladungsflusses in der in Fig. 4 gezeigten Struktur,

Fig. 4G mehrere Kurven zur Darstellung der Steuerspannung an jeder Elektrode der in Fig. 4 gezeigten Struktur und

Fig. 5 die horizontale Lage des seriellen-parallelen-seriellen zeilenadressierbaren Speichers der vorliegenden Erfindung.

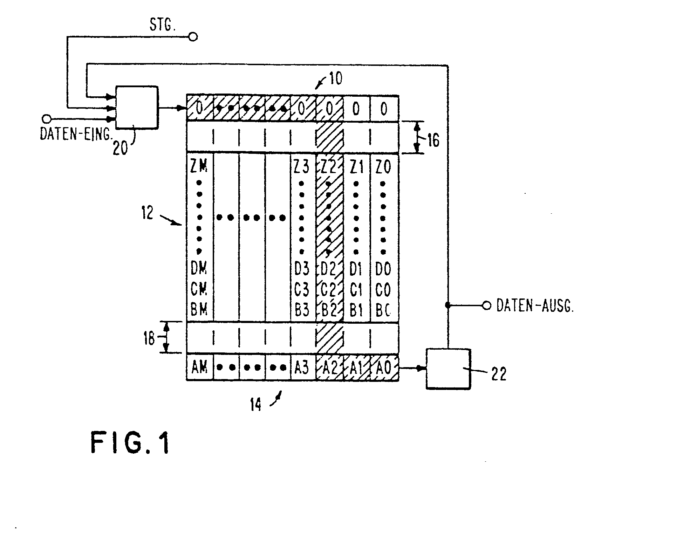

Fig. 1 zeigt schematisch eine serielle-parallele-serielle Konfiguration (SPS) mit einem seriellen Eingangsregister 10, einem parallelen Mittelteil 12 und einem seriellen Ausgangsregister 14. Derartige Schaltungsanordnungen enthalten häufig auch noch einen Serien/Parallelwandler 16 und einen Parallel/Serienwandler 18. Leitungs-, Takt- und Nachladeschaltungen für solche SPS-Konfigurationen sind allgemein bekannt und im Leit- und Taktschaltblock 20 schematisch dargestellt. Ebenfalls an sich bekannt sind Ladungsabfühl- und Verstärkerschaltungen mit Rücklaufverstärkern, wie sie allgemein durch den Abfrageverstärker 22 dargestellt sind. Ein Signal am Steuereingangsanschluss bestimmt, wann neue Daten am Dateneingangsanschluss oder vom Abfrageverstärker 22 zurückgeführte Daten in die erste Bitposition des seriellen Eingaberegisters 10 einzugeben sind. Auch im Umlaufbetrieb können Daten am Datenausgangsanschluss gleichzeitig genutzt werden.

Eine erfindungsgemässe Schaltung kann voll als standardmässige SPS-Schaltungskonfiguration betrieben werden. Auf bekannte Weise werden Datenbits seriell von links nach rechts in das serielle Eingangsregister 10 eingegeben. Wenn die gewünschte Anzahl von Bits in das Eingangsregister 10 eingegeben ist, werden sie parallel über den Serien/Parallelwandler 16 in eine erste Zeile des parallelen Mittelteiles 12 eingegeben. Dann werden neue Daten in das serielle Eingaberegister 10 eingegeben und wieder durch den Serien/Parallelwandler 16 in die erste Zeile des parallelen Mittelteiles 12 eingegeben, während die vorher dort stehenden Daten in die zweite Zeile gesetzt werden. Auf diese Weise wird der parallele Mittelteil 12 zeilenweise mit Daten gefüllt. Wenn die zuerst eingegebenen Daten die letzte Zeile des parallelen Mittelteiles 12 erreichen, werden sie parallel durch den Parallel/Serienwandler 18 in das serielle Ausgangsregister 14 gegeben. Hier werden Daten bitweise in den Abfrageverstärker 22 und von dort weiter an den Datenausgangsanschluss und an den angegebenen Eingang des Leit- und Taktschaltblockes 20 weitergeleitet. Im Umlaufbetrieb werden die Daten am Datenausgangsanschluss nicht benutzt, sondern die vom Abfrageverstärker 22 kommenden Bits werden über den Leit- und Taktschaltblock 20 wieder in das serielle Eingaberegister 10 eingegeben. Durch diesen dauernden Umlauf des Datenbitstromes wird ein Informationsverlust in den Ladungskopplungselementen verhindert.

Im folgenden wird das Ziel verfolgt, Daten auf bekannte Art einer SPS-Struktur umlaufen zu lassen, wie es oben beschrieben wurde. Ein Datensatz muss jedoch eingegeben und ausgegeben werden können, wie es schraffiert in Fig. 1 dargestellt ist. Zur besseren Beschreibung wurden die Bitpositionen in Fig. 1 bezeichnet. Die Anordnung enthält N-1 Zeilen im parallelen Mittelteil, von denen die erste Zeile die Z Bits speichert, während die N-1 Zeile die B Bits speichert. (M + 1) x N Bits werden insgesamt gespeichert, da die A Bits im seriellen Ausgaberegister gespeichert werden. Jede Spalte speichert einen gewünschten Datensatz, der aus den Datenbits A bis Z besteht. Die schraffierten Zellen zeigen die serielle Bahn, auf der ein Datensatz eingegeben oder ausgegeben wird.

Insbesondere der Datensatz 2, d.h. A2 B2 ... Z2, ist in Ruheposition gezeigt. Der Datensatz ist analog der zeilenadressierbaren Spalte einer herkömmlichen zeilenadressierbaren Struktur. In diesem Beispiel wurde das Eingaberegister 10 mit Nullbits gefüllt. Nach dem Erfindungsgedanken kann man die schraffierten Bits in folgender Reihenfolge auslesen: A0, A1, A2, B2 bis Z2 und die Nullbits, wie es im schraffierten Teil des Registers dargestellt ist. Während diese Bits am Datenausgangsanschluss ausgelesen werden, werden sie auch durch den Leit- und Taktschaltblock 20 umlaufen gelassen, so dass am Ende der Operation genau die Konfiguration wieder hergestellt ist, die in Fig. 1 gezeigt ist. Jetzt kann man entweder einen anderen Datensatz, z.B. A3 bis Z3, adressieren oder die Erneuerung mit einer herkömmlichen SPS-Operation wieder aufnehmen. Während eine gewünschte Zeile adressiert wird, bleiben natürlich alle anderen Bits in den parallelen Kanälen inaktiv, d.h. sie werden nicht weitergeleitet.

In den schraffierten Teilen des Eingabe- und des Ausgaberegisters befinden sich noch (M + 1) zusätzliche Bits, die zusammen mit dem nutzbaren Datensatz bewegt werden müssen, von den logischen Schaltungen des Systems jedoch ignoriert werden.

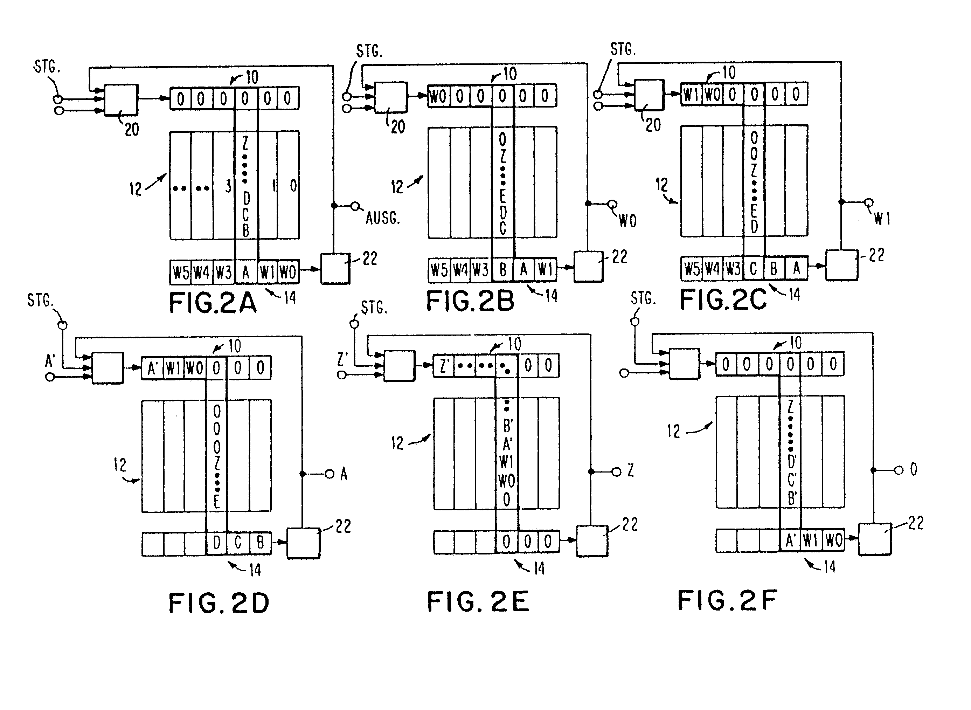

Das in den Fign. 2A bis 2F im einzelnen gezeigte Beispiel verwendet das in Fig. 1 dargestellte Ausführungsbeispiel, in dem die leeren oder Nullbits im Eingaberegister 10 stehen. Der Serien/Parallelwandler 16 und der Parallel/Serienwandler 18 aus Fig. 1 wurden der einfacheren Darstellung halber absichtlich weggelassen. Die Bezeichung der Bits wurde aus demselben Grund geringfügig geändert.

Unter Bezug auf Fig. 2A wird angenommen, dass der Datensatz Nr. 2, bestehend aus den Bits A, B, C, D bis Z die zu adressierende Zeile ist. Da es der dritte Datensatz ist, weist ein Zähler am Ausgangsanschluss im Benutzergerät darauf hin, dass die Bits W0 und W1 den ersten beiden Datensätzen entsprechen und daher nicht Teil der adressierten Zeile sind. Nach Darstellung in Fig. 2B ist also das Bit W0 das erste ausgehende Bit, das auch in die erste Bitposition im seriellen Eingaberegister 10 geschrieben wird, wenn jedes Bit um eine Position verschoben wird. Fig. 2C zeigt die Situation, wenn jedes Bit um eine weitere Position verschoben wurde, wobei W1 ausgelesen und in die erste Bitposition in das serielle Register 10 gesetzt wird, während alle anderen Bits entsprechend um eine Position verschoben werden. In Fig. 2D ist gezeigt, wie das Auslesen der adressierten Zeile beginnt mit dem Auslesen von Bit A. Um die Situation besser darzustellen, in der dieselben Daten nicht umlaufen gelassen werden, wird ein neues Bit A mit der Bezeichnung A' an den Eingangsanschluss angelegt und in die erste Bitposition des Eingaberegisters 10 gesetzt. Alle Bits werden entsprechend verschoben, wie vorher beschrieben.

Dieser Ausschiebeprozess des gewünschten Datensatzes geht weiter, während die neuen Bits eingeschoben werden, bis der in Fig. 2E gezeigte Zustand erreicht ist. Hier wurde das letzte Bit (Z) an den Datenausgangsanschluss gegeben und das neue Bit Z' in die erste Position des Eingaberegisters 10 gesetzt. An diesem Punkt sind die Daten fertig ausgelesen, obwohl noch einige weitere Zyklen erforderlich sind, um die Datenbits in ihre Ausgangsposition zurückzuschieben. Das ist in Fig. 2F gezeigt, wo alle Datenbits wieder in ihrer ursprünglichen Position stehen und die Bits A', B', C', D' bis Z' ihre ursprünglichen Bits ohne die Strichbezeichnung in Fig. 2A ersetzt haben. Auf diese Weise arbeitet ein serieller-parallelerserieller Speicher im Zeilenadressbetrieb, wo jeder gewünschte Datensatz beliebig adressiert werden kann. Der Vorteil dieser Struktur besteht in der offensichtlichen Reduzierung der Latenzzeit. Wenn der Datensatz Z der Fig. 1 gewünscht wird, muss man im herkömmlichen SPS-Betrieb warten, bis die ganze Gruppe adressiert ist. Durch das gezeigte LA-SPS-Betriebsverfahren beläuft sich die Latenzzeit im ungünstigsten Falle auf die Schiebezeit von M Bits, wenn irgendein Datensatz gewünscht wird. Für den in Fig. 1 gezeigten Fall ist die Latenzzeit nur genauso gross, wie die Schiebezeit für die Bits A0 und A1. Eine weitere Verschiebung muss jedoch vorgenommen werden, um die Daten wieder in ihre ursprüngliche Konfiguration zu setzen und die Operation zu beenden.

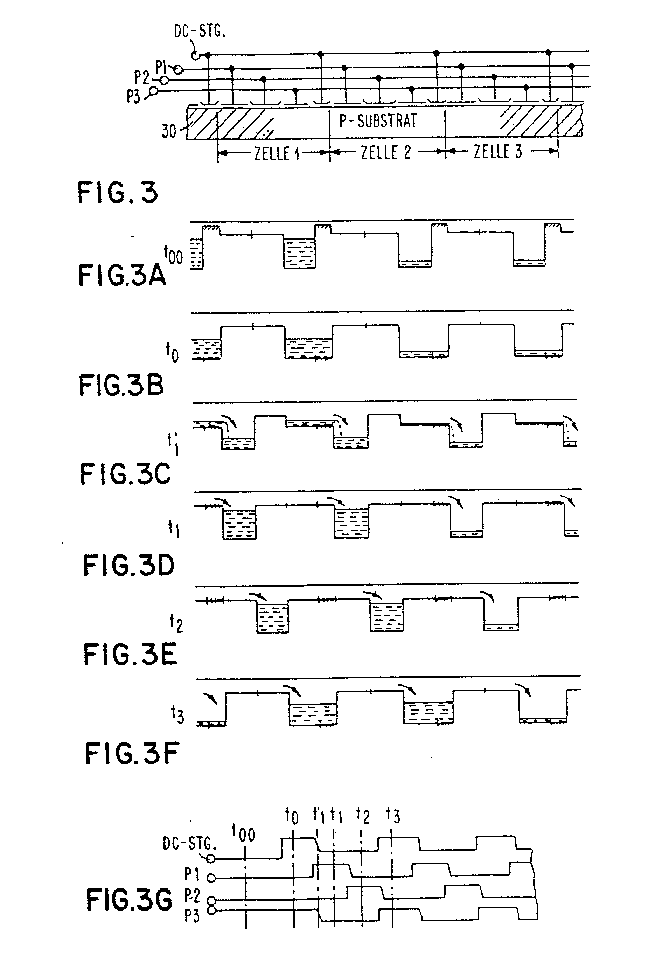

Eine beispielhafte Struktur zur Ausführung dieser Funktion ist in Fig. 3 gezeigt, die ein P-leitendes Substrat 30 darstellt. Da ein dreiphasiges CCD-Schieberegister seine Direktionalität bekanntlich aus der Reihenfolge der Taktphasenpulse erhält, werden keine Ionenimplantationen benötigt. Drei Zellen sind besonders dargestellt, um die Anordnung der Elektroden für die Phase 1 (P1), die Phase 2 (P2), die Phase 3 (P3) und das Steuergate zu zeigen. Die Steuerleitungen für die Phasen 1 und 3 sind als Poly 1 dargestellt, während das Steuergate und die Leitung für die Phase 2 als Poly 2 gezeigt sind. Weitere Einzelheiten wie die Bildung der Oxide und der beiden Anordnungsebenen für Poly 1 und Poly 2 sind in Fachkreisen allgemein bekannt.

Anschliessend werden die Betriebsmerkmale beschrieben, nach denen die in Fig. 3 gezeigte Speicheranordnung als SPS-Speicher im Weiterleitungsbetrieb als auch als zeilenadressierbarer Speicher im Nichtweiterleitungsbetrieb betrieben werden kann. Zuerst wird der Weiterleitungsbetrieb beschrieben. Darunter versteht man entweder den Betrieb eines jeden Kanales während des SPS-Betriebes oder die Einzelkanalweiterleitung während des Zeilenadressierbetriebes. Die Fign. 3A bis 3F zeigen die verschiedenen Energieniveaus während der Weiterleitung und die Fig. 3G die relativen Spannungspegel, die zur Erzeugung der gezeigten Energieniveaus erforderlich sind.

Zur Zeit $t_{00}$ werden die Leitungen für das Steuergate, die Phase 1 und die Phase 2 auf einem niedrigen Pegel gehalten, während die Leitung für die Phase 3 auf einem hohen Pegel gehalten wird. Je höher der obere Pegel ist, desto tiefer ist der resultierende Potentialtopf, während die Sperre umso höher ist, je negativer der untere Pegel ist. Aus Fig. 13A ist zu ersehen, dass das Steuergate auf dem negativsten Potential liegt, was zu der höchsten Sperre führt, während der Takt P3, der auf einem positiven Potential liegt, einen Potentialtopf erzeugt. Die Elektroden für die Phase 1 und die Phase 2 werden auf demselben niedrigen Potential gehalten, das etwas positiver ist, als das niedrige Potential am Steuergate. Im vorliegenden Beispiel enthält die Zelle direkt vor der Zelle 1 und die Zelle 1 eine binäre 1, während die Zellen 2 und 3 fette Nullen enthalten.

In Fig. 3B ist das Energieniveau gezeigt, das herrscht, wenn die Steuergateelektrode zur Zeit $t_0$ auf den hohen Pegel gebracht wird. Dadurch wird ein breiterer Potentialtopf geschaffen, um die Ladung aufzunehmen, die vorher nur unter der Elektrode der Phase 3 gehalten wurde. Die Steuergateelektrode ist etwas schmaler als die anderen Phasenelektroden. Diese Raumeinsparung ist möglich, weil es sich hier nur um eine Sperrelektrode handelt, die keine volle Ladung halten muss.

Fig. 3C zeigt das Energieniveau zur Zeit $t'_1$, wenn die Steuergateelektrode auf einen niedrigen Pegel gebracht wird, der nicht ganz so negativ ist, wie der niedrige Anfangspegel zur Zeit $t_{00}$. Die Elektrode für die Phase 1 wurde auf einen hohen Pegel gebracht und die Elektrode für die Phase 3 ebenfalls auf einen niedrigen Pegel. Dadurch läuft die Ladung unter die Elektrode der Phase 1 über, während das daran angelegte hohe Potential den tiefsten Potentialtopf bildet. Zur Zeit $t_1$ stabilisiert sich der oben erwähnte Zustand, wobei die ganze Ladung unter der Elektrode der Phase 1 gemäss Darstellung in Fig. 3D liegt.

Zur Zeit $t_2$ wird die Elektrode der Phase 1 auf einen niedrigen und die Elektrode der Phase 2 auf einen hohen Pegel gebracht, so dass die Ladung unter die Elektrode der Phase 2 gebracht wird gemäss Darstellung in Fig. 3E.

Zur Zeit $t_3$ liegen das Steuergate und die Elektrode der Phase 3 darstellungsgemäss auf einem hohen Pegel, während die Takte der Phase 1 und der Phase 2 niedrig sind. Der Takt der Phase 2 schiebt beim Abfallen auf einen niedrigen Pegel die Ladung unter die Elektrode der Phase 3 und die Steuergateelektrode, wie es in Fig. 3F gezeigt ist. Aus dem Zeitplan in Fig. 3G ist zu ersehen, dass als nächstes der hohe Pegel der Elektrode für die Phase 1 auftritt und unter der ersten Elektrode der Zelle 2 einen Potentialtopf erzeugt. Der abwärts gerichtete Übergang des Taktes für das Steuergate und des Taktes der Phase 3 schieben die vorher darunter befindliche Ladung (Fig. 3F) und die Elektrode der Phase 1 der nächstfolgenden Zelle usw. Die binäre 1 sowie die Null wird also von einer Zelle zur nächsten in der gezeigten Art weitergeleitet.

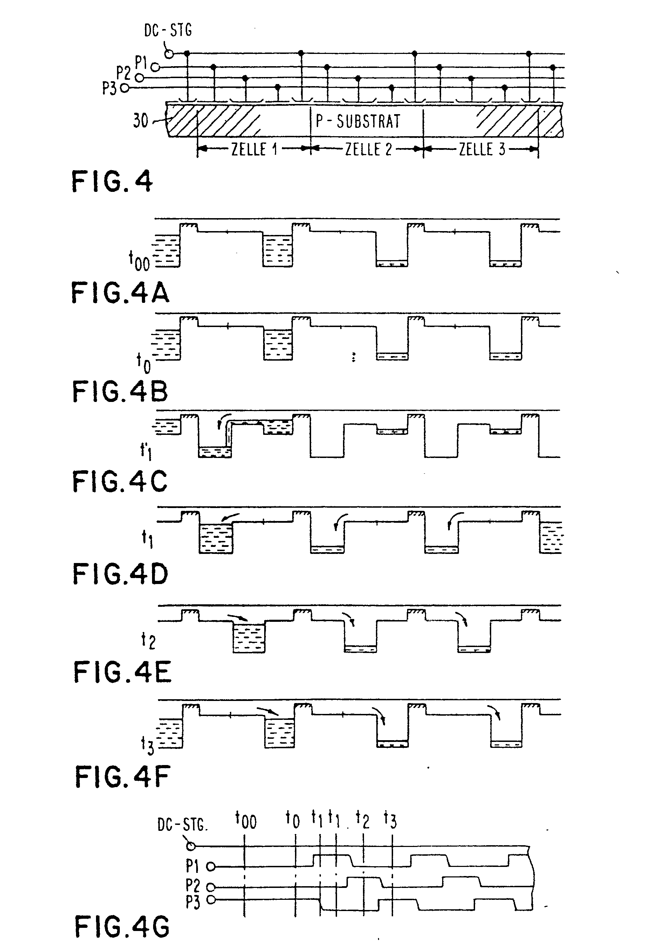

Fig. 4 zeigt die gleiche Struktur wie Fig. 3. In Verbindung mit den Fign. 4 und 4A bis 4G wird der Zustand in den inaktiven Kanälen während des Zeilenadressierbetriebes beschrieben. Während der adressierte Kanal also so arbeitet, wie es im Zusammenhang mit den Fign. 3A bis 3G beschrieben wurde, arbeiten die übrigen Spalten und die inaktiven Teile der seriellen Eingabe- und Ausgaberegister entsprechend den in Fig. 4G gezeigten angelegten Potentialen und den in den Fign. 4A bis 4F gezeigten Energieniveaus.

Zur Zeit $t_{00}$ ist der Taktimpuls der Phase 3 auf einem hohen Pegel, während alle anderen Taktimpulse auf einem niedrigen Pegel liegen. Das negativste Potential liegt am Steuergate an und liefert eine energiereiche Sperre, die bei der beschriebenen Betriebsart überhaupt nicht verändert wird. Bei der Darstellung der Energieniveaus zur Zeit $t_{00}$ in Fig. 4A ist die Sperre mit hohem Potential unter jeder Steuerelektrode zu sehen. Der tiefste Potentialtopf liegt unter der Elektrode für die Phase 3, wo eine binäre 1 in der Zelle 1 und der unmittelbar vorhergehenden Zelle gespeichert wird, während in den Zellen 2 und 3 Nullen gespeichert werden. Für dieses Beispiel ist eine binäre 1 ebenfalls in der Zelle hinter der Zelle 3 gespeichert. Zur Zeit $t_0$ hat sich keines der an die Elektroden angelegten Potentiale geändert, so dass die Energieniveaus zur Zeit $t_0$, dargestellt in Fig. 4B, mit denen identisch sind, die in Fig. 4A gezeigt sind. Zur Zeit $t'_1$ wurde die Elektrode der Phase 1 auf ein hohes Niveau gebracht und so darunter ein Potentialtopf erzeugt. Ein niedriger Pegel wird an die Elektrode der Phase 3 angelegt, so dass die Ladung der binären 1 über die von der Elektrode der Phase 2 gebildete Sperre in den unter der Elektrode der Phase 1 erzeugten Potentialtopf «zurückschwappt». Die von der Elektrode der Phase 2 errichtete Sperre ist jedoch hoch genug, um die Übertragung fetter Nullen unter die Elektroden der Phase 1 zu verhindern. Dieser Zustand ist für die Zellen 2 und 3 in Fig. 4C gezeigt. Zur Zeit $t_1$ ist der abwärts gerichtete Übergang des Taktimpulses für die Phase 3 beendet, so dass die Potentiale an den Elektroden für die Phasen 2 und 3 auf denselben niedrigen Pegel gebracht werden, was in dem Energieniveaubild der Fig. 4D resultiert. Nach Darstellung in Fig. 4D wurde also die gesamte Ladung für die binäre 1 sowie für die fette Null aus ihrer Lage unter der Elektrode der Phase 3 übertragen unter die Elektrode der Phase 1 innerhalb derselben Zelle.

Hinterher wird die Elektrode der Phase 2 auf ein hohes Niveau gebracht und so darunter ein Potentialtopf geschaffen. Wenn die Elektrode der Phase 1 auf ein niedriges Niveau gebracht wird, wird dann die Ladung zur Zeit $t_2$, gemäss Darstellung in Fig. 4E, aus ihrer Lage unter der Elektrode der Phase 1 übertragen in eine Lage unter der Elektrode der Phase 2. Zu diesem Zeitpunkt sind die Elektroden für die Phasen 1 und 3 auf demselben niedrigen Potentialniveau und halten die gesamte Ladung (entweder die binäre 1 oder die Null) unter der Elektrode der Phase 2, und zwar wieder innerhalb derselben Zellen.

Anschliessend wird die Elektrode der Phase 3 wieder auf ein hohes Niveau gebracht und dadurch ein Potentialtopf geschaffen. Die Elektrode der Phase 2 wird auf ein niedriges Niveau gebracht und so die Ladung aus ihrer Lage unter der Elektrode der Phase 2 in den unter der Elektrode der Phase 3 geschaffenen Potentialtopf übertragen, was in dem in Fig. 4F gezeigten Zustand zur Zeit $t_3$ resultiert. Zu diesem Zeitpunkt ist ein ganzer Zyklus beendet und alle Ladungspakete mit den binären Einsen und den fetten Nullen wieder an dieselben Positionen gebracht, die sie zur Zeit $t_{00}$ hatten. Von hier an wiederholen sich die Wellenzüge so lange, wie es erforderlich ist, um die Ladung in den inaktiven Kanälen «stationär» zu halten, während der gewünschte Kanal adressiert wird.

In dem Diagramm in Fig. 4G wird die Steuergateelektrode immer auf einem niedrigen Pegel gehalten und zu ihrem Betrieb brauchen keine Taktimpulse angelegt zu werden. Aus den Wellenzügen in Fig. 3G ist zu ersehen, dass der Spannungsverlauf für das Steuergate und für die Phase 3 identisch sind. Das wird erreicht durch einfache Verbindung des Steuergates mit der Leitung er Phase 3. Wiederum ist für das Steuergate kein separater Phasentakt erforderlich. Ausserdem sind die Wellenzüge für P1, P2 und P3 in den Fign 3G und 4G identisch, da sie gleichzeitig an den gewählten und an den nichtgewählten Kanal angelegt werden.

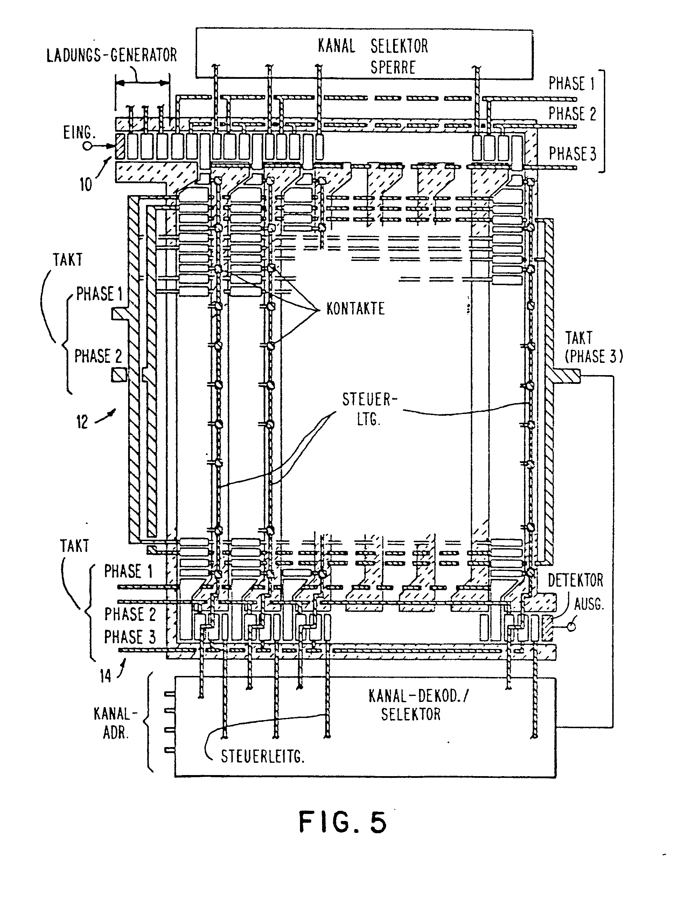

Fig. 5 zeigt primär den Lauf der Takt- und Steuerleitungen. Das serielle Eingaberegister 10, der parallele Mittelteil 12 und das serielle Ausgaberegister 14 sind wieder genauso numeriert wie in den vorhergehenden Zeichnungen. Das serielle Eingaberegister 10 empfängt eine Eingabe in einem Erzeugungsteil und es empfängt die Verbindung der Elektroden für die Phase 1 und die Phase 2. Zusätzlich zum herkömmlichen zweiphasigen seriellen Eingaberegister sind hier die Sperrleitungen vom Kanalwähler vorhanden. Hierbei handelt es sich um die oben beschriebenen Gleichstrom-Steuerleitungen, die während der Zeilenadressierung selektiv aktiviert werden müssen. Datenbits werden im SPS-Betrieb in allen seriellen Eingaberegistern und im Zeilenadressierbetrieb selektiv übertragen, abhängig von der adressierten Zeile, wie es beispielsweise im Zusammenhang mit Fig. 1 beschrieben wurde. Die beiden Zellengruppen des seriellen Eingaberegisters 10 sind genauso angeordnet, wie es oben im Zusammenhang mit den Fign 3 und 4 beschrieben wurde.

Im parallelen Teil ist jede Zellenspalte so angeordnet, wie es oben im Zusammenhang mit den Fign. 3 und 4 beschrieben wurde. Die Verbindung der parallelen Kanaltaktleitungen für die Phasen 1, 2 und 3 ist besonders dargestellt. Die zeitliche Beziehung der drei Phasenleitungen im seriellen und parallelen Teil wird so gewählt, wie es in den Fign. 3G und 4G gezeigt ist.

Insbesondere sind die parallelen Kanalsteuerleitungen zu beachten, die in diesem Beispiel aus Metall sind. Diese Leitungen laufen an jeder Spalte im parallelen Kanal entlang und haben an jeder Zellenlage Metallkontakte zu den Leitern auf der unteren Stufe. Diese Kontakte können wie oben beschrieben zu einem Leiter der unteren Stufe führen, und dann kann die Anordnung aus Poly 1 und Poly 2 verwendet werden. Wie schon im Zusammenhang mit den Fign. 3 und 4 beschrieben wurde, wäre die Phasenleitung 1 dann Poly 1, die Phasenleitung 2 wäre Poly 2, die Phasenleitung 3 wäre Poly 1 und die Steuergateleitung wäre wieder Poly 2. So sind nur zwei Stufen von Gateelektroden erforderlich, um die Weiterleitungsfunktion und die Nichtweiterleitungsfunktion zu liefern. Die parallelen Kanalsteuerleitungen können über den Kanaldecodierer/wähler mit der Phasenleitung 3 verbunden werden für den im Zusammenhang mit den Fign. 3A bis 3G beschriebenen Betrieb. Andererseits sperrt der Kanaldecodierer/wähler alle Spalten mit Ausnahme von einer Spalte mit einem an die parallelen Steuerleitungen angelegten niedrigen Pegel und verbindet nur die eine gewählte parallele Kanalsteuerleitung mit der Taktphase 3. Auf diese Weise wird der Spaltenadressierbetrieb verwirklicht.

Im Ausgaberegister 14 werden die seriellen Kanalsteuerleitungen vom Kanaldecodierer/wähler gesteuert, um Daten im Drei-Phasenbetrieb auszulesen. Im SPS-Betrieb werden Daten in paralleler Form aus der letzten Zeile im parallelen Teil 12 in das Ausgaberegister 14 gelesen und von dort bitweise über den Detektor an den Ausgangsanschluss. Im Zeilenadressierbetrieb wird die gewünschte Anzahl serieller Kanalsteuerleitungen im Weiterleitungsbetrieb aktiviert, während die übrigen Leitungen im nichtweiterleitenden Zustand gehalten werden. Das geschieht genauso wie im parallelen Teil gemäss der obigen Beschreibung im Zusammenhang mit den Fign. 3 und 4, um den selektiven Zeilenadressierbetrieb zu erreichen, der im Zusammenhang mit den Fign. 1 und 2A bis 2F beschrieben wurde.

**Patentanspruch**

1. Zeilenadressierbarer Speicher in Serien-Parallel-Serien-Konfiguration mit Ladungskopplungselementen in drei Hauptteilen des Speichers, wovon der erste ein serielles Eingabeschieberegister (10) zum Empfang von Datenbits ist, der zweite ein serielles Ausgabeschieberegister (14) und der dritte parallele Schieberegister (12) umfasst, von denen jedes zwischen einer Speicherposition des Eingabeschieberegisters (10) und einer Speicherposition des Ausgabeschieberegisters (14) angeordnet ist, um Datenbits mittels auf einem Substrat (30) angeordneter, zu jedem der parallelen Schieberegister (12) gehörender, erster, zweiter und dritter Phasensteuerleitungen (P1, P2, P3) und Steuerleitungen (DC-STG) für Steuergates vom Eingabeschieberegister (10) zu empfangen und Datenbits aus der letzten Zeile eines Schieberegisters (12) des dritten Teils in das serielle Ausgaberegister (14) zu übertragen, wobei die Phasensteuerleitungen (P1, P2, P3) orthogonal zu den parallelen Schieberegistern (12) und parallel zueinander verlaufen, die Steuerleitungen (DC-STG) parallel zu den Schieberegistern (12) und orthogonal zu den Phasensteuerleitungen (P1, P2, P3) angeordnet sind und die Elektroden, die mit den Leitungen (P1, P2, P3, DC-STG) verbunden sind, nebeneinander auf dem Substrat (30) angebracht sind, dadurch gekennzeichnet, dass Elektroden der Steuerleitungen (DC-STG) nur jeweils zwischen den dritten und ersten Phasensteuerleitungen (P3, P1) vorhanden sind und alle Steuerleitungen (DC-STG) so schaltbar sind, dass ein angelegtes Steuersignal die Weiterleitung von Datenbits von einer zu einer der folgenden Zeilen nur eines der parallelen Schieberegister (12) oder aller parallelen Schieberegister (12) sperrt oder zulässt.

**Claim**

1. Line-addressable storage in serial-parallel-serial configuration with charge coupling elements in three main sections of the storage, the first being a serial input shift register (10) receiving data bits, the second a serial output shift register (14), and the third comprising parallel shift registers (12), each being arranged between a storage position of the input shift register (10) and a storage position of the output shift register (14) receiving data bits by means of first, second and third phase control lines (P1, P2, P3) belonging to each of the parallel shift registers (12), and control lines (DC-STG) for control gates from the input shift register (10), and to transfer data bits from the last line of a shift register (12) of the third section into the serial output register (14), the phase control lines (P1, P2, P3) being arranged orthogonally to the parallel shift registers (12) and extending in parallel to each other, and the control lines (DC-STG) being arranged in parallel to the shift registers (12) and orthogonally to the phase control lines (P1, P2, P3), and the electrodes connected to the lines (P1, P2, P3, DC-STG) being arranged one beside the other on the substrate (30), characterized in that electrodes of the control lines (DC-STG) exist only between the respective third and first phase control lines (P3, P1), and in that all control lines (DC-STG) are operable in such a manner that an applied control signal blocks or permits the transfer of data bits from one line to one of the following lines of only one of the parallel shift registers (12), or of all parallel shift registers (12).

**Revendication**

1. Mémoire adressée par ligne à configuration série-parllèle-série comportant des éléments de couplage de charge dans trois parties principales de la mémoire, dont la première est un registre à décalage d'entrée série (10) destiné à recevoir des bits d'information, la seconde comprend un registre à décalage de sortie série (14) et la troisième des registres à décalage parallèles (12) dont chacun est placé entre une position de mémoire du registre à décalage d'entrée (10) et une position de mémoire du registre à décalage de sortie (14), pour recevoir des bits d'information au moyen d'une première, seconde et troisième lignes de commande de phase (P1, P2, P3) placées sur un substrat (30), appartenant à chacun des registres à décalage parallèles (12), et de lignes de commande (DC-STG) pour des portes de commande du registre à décalage d'entrée (10), et transférer des bits d'information provenant de la dernière ligne d'un registre à décalage (12) de la troisième partie, au registre de sortie série (14), les lignes de commande de phase (P1, P2, P3) étant orthogonales aux registres à décalage parallèles (12) et parallèles entre elles, les lignes de commande (DC-STG) étant disposées parallèlement aux registres à décalage (12) et perpendiculairement aux lignes de commandes de phase (P1, P2, P3) et les électrodes reliées aux lignes (P1, P2, P3, DC-STG) étant disposées côte à côte sur le substrat (30), caractérisée en ce que des électrodes des lignes de commande (DC-STG) ne sont seulement présentes qu'entre les troisième et première lignes de commande de phase (P3, P1) et en ce que toutes les lignes de commande (DC-STG) peuvent être branchées de façon telle qu'un signal de commande appliqué interdise ou autorise la transmission de bits d'information d'une ligne à l'une des lignes suivantes d'un seul des registres à décalage parallèles (12) ou de tous les registres à décalage parallèles (12).

FIG.1

FIG.2A

FIG.2B

FIG.2C

FIG.2D

FIG.2E

FIG.2F

FIG.3

FIG.3A

FIG.3B

FIG.3C

FIG.3D

FIG.3E

FIG.3F

FIG.3G

0 012 841

FIG.4

FIG.4A

FIG.4B

FIG.4C

FIG.4D

FIG.4E

FIG.4F

FIG.4G

15

FIG. 5

17